# EUROPEAN PATENT APPLICATION

(11) **EP 2 077 617 A2**
(43) Date of publication of application: **08.07.2009**
(21) Application number: 08254132.7
(22) Date of filing: 23.12.2008
(51) Int. Cl.: H03H 9/05

(54) **Metal base for crystal unit and crystal unit using the same**

(30) Priority: 28.12.2007 JP 2007339162
(71) Applicant: Nihon Dempa Kogyo Co., Ltd., Tokyo 151-8569 (JP)
(72) Inventor: Miyashita, Keisuke, Sayama-shi, Saitama 350-1321 (JP); Obara, Shigeru, Sayama-shi, Saitama 350-1321 (JP); Kusunoki, Toyoaki, Sayama-shi, Saitama 350-1321 (JP)
(74) Representative: MacDougall, Alan John Shaw

(57) **Abstract**

The metal base for a crystal unit includes: a base body in which at least a pair of through-holes are formed; a pair of leads provided with a supporter for supporting a crystal blank at the head thereof; and glass charged into the respective through-holes to electrically insulate the leads from the base body and hermetically seal the through-holes. A step is formed in a region of the lead corresponding to the outer bottom surface of the base body, the lead is made up of at least a first lead portion on the through-hole side from the step and a second lead portion in a direction in which the lead extends out from the step. The diameter of the lead of the second lead portion is smaller than the diameter of the lead of the first lead portion.

## Description

### BACKGROUND OF THE INVENTION:

### 1. Field of the Invention

The present invention relates to a quartz crystal unit that holds a quartz crystal blank on a metal base and hermetically encapsulates this crystal blank within a container made up of the metal base and a cover. The present invention more particularly relates to a metal base capable of preventing cracks such as crazing or chipping of glass from occurring in portions where leads configured as hermetic terminals penetrate the base body and keeping the container airtight, and a crystal unit using such a metal base.

### 2. Description of the Related Art

Quartz crystal units having a structure with a quartz crystal blank hermetically encapsulated within a container have a high degree of stability of a vibration frequency thereof, and are therefore used, for example, as a frequency source for a radio device such as a base station on a communication network. The crystal blank making up such a crystal unit is classified into several types of "cuts" according to a crystallographic orientation when the crystal blank is cut out from a single crystal of quartz. As such cutting, for example, X-cut, AT-cut, BT-cut or the like are conventionally known. For crystal units for communication devices, those having an AT-cut crystal blank are conventionally widely used.

Crystallographically, three crystal axes of X-axis, Y-axis and Z-axis are defined for a crystal of quartz. When a plane orthogonal to one of such three crystal axes of quartz is rotated by a predetermined angle around one of the two remaining crystal axes and a crystal blank is then cut out from the crystal of quartz along the plane rotated by another predetermined angle around the final crystal axis from the rotated position, a crystal unit having such a crystal blank is called a "double-rotation crystal unit." For example, a crystal unit having a crystal blank cut out from a crystal of quartz along a plane obtained by sequentially rotating the plane orthogonal to the Y-axis around the remaining two crystal axes respectively is called a "crystal unit with a double-rotation Y-cut plate."

In recent years, crystal units having an SC-cut quartz crystal blank, which is one type of double-rotation Y-cut plate, are used for a high stability crystal oscillator for a radio base station because such crystal units have excellent stress insensitive characteristic and thermal shock resistance characteristic in that crystal blank. The principal plane of the SC-cut crystal blank is a plane obtained by rotating the plane perpendicular to the Y-axis of the quartz crystal by approximately 22 degrees around the X-axis and then rotating the plane by approximately 34 degrees around the Z-axis.

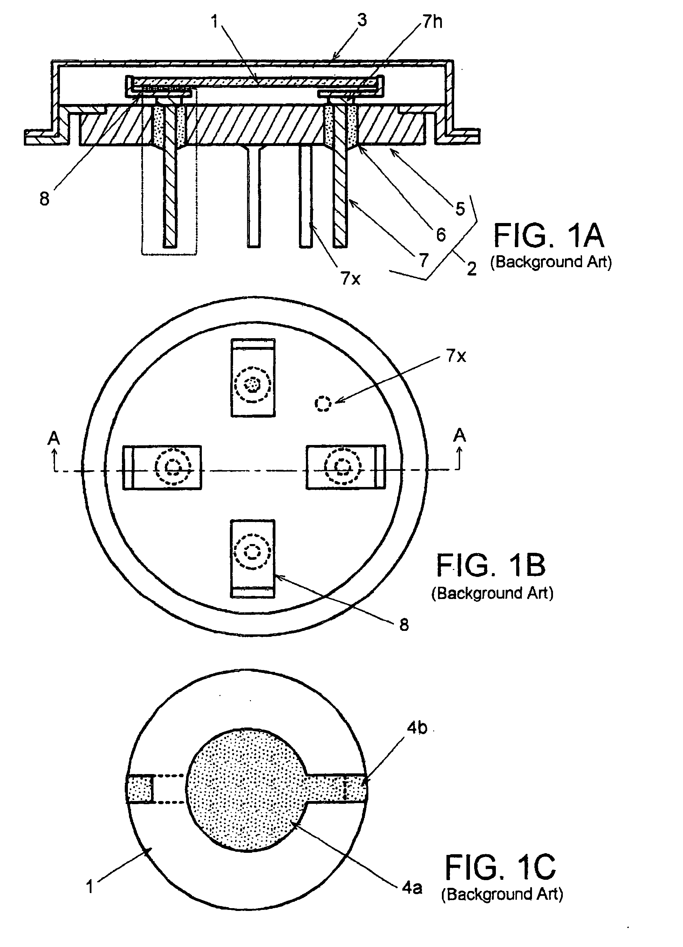

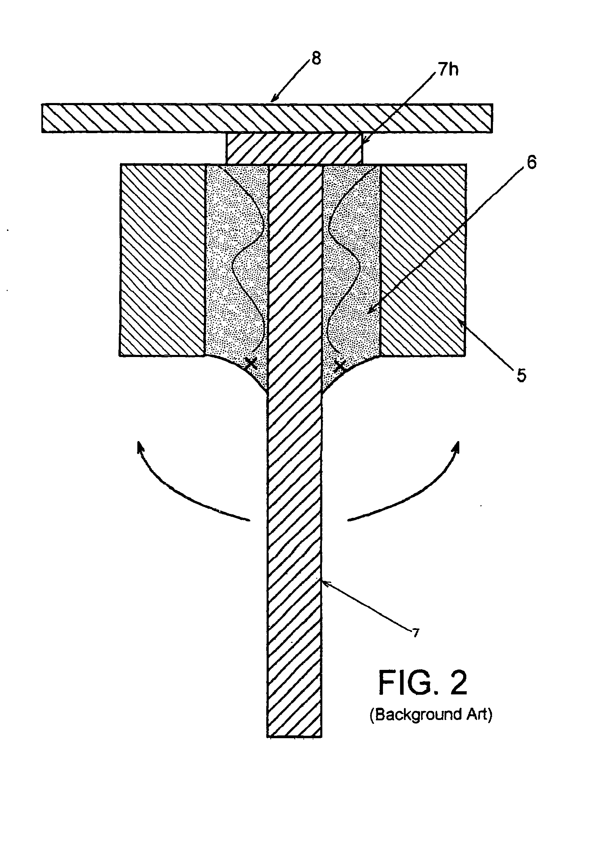

FIG: 1A is cross-sectional view of a conventional crystal unit with an SC-cut crystal blank hermetically encapsulated within a container, and FIG. 1B is a plan view of the crystal unit shown in FIG. 1A with a cover removed. FIG. 1C shows an SC-cut crystal blank. Although the cover is shown in FIG. 1A, FIG. 1A corresponds to a cross-sectional view along line A-A of FIG. 1B. FIG. 2 shows an enlarged view of the portion enclosed by a dotted line in FIG. 1A.

The crystal unit shown in the figure holds SC-cut crystal blank 1 on metal base 2, covers metal base 2 with metal cover 3 and hermetically encapsulates crystal blank 1 within the space surrounded by metal base 2 and metal cover 3.

Metal base 2 includes metal base body 5 having a disk-like shape and four metal leads 7 provided so as to penetrate base body 5. Through-holes are formed in base body 5 at positions quartering the circumference of a circle concentric with base body 5 and leads 7 are inserted in these four respective through-holes. The space between lead 7 and base body 5 in the through-hole is filled with glass 6 and the through-holes are hermetically sealed. Lead 7 and base body 5 are electrically insulated by glass 6. In this way, the hermetic terminal is made up of lead 7 and glass 6.

In the following explanations, of the two principal surfaces of base body 5, the principal surface facing crystal blank 1 is called an "inner bottom surface" and the other principal surface is called an "outer bottom surface."

Head 7h of each lead 7, that is, an end of lead 7 that supports crystal blank 1 is worked into a small disk shape like the head of a nail, protrudes from the inner bottom surface of base body 5 and in this way lead 7 has a T-shaped cross section. Head 7h adheres onto glass 6 that seals the through-hole. The diameter of small disk-like head 7h is smaller than the diameter of the region where glass 6 is formed so as to prevent lead 7 from electrically connecting to base body 5. Grounding lead 7x is also connected to the outer bottom surface of base body 5.

When leads 7 are inserted into the through-holes of base body 5 to configure hermetic terminals, cylindrical tablets molded by solidifying glass powder are fitted to leads 7 so as to contact the lower surfaces of small disk-like heads 7h. Leads 7 to which the glass tablets are fitted are inserted into the through-holes of base body 5, heated so as to bake and melt the glass tablets and then cooled. This causes a glass layer to be formed between leads 7 and inner walls of the through-holes. In this case, the diameter of the glass tablet is made smaller than the inner diameter of the through-hole to facilitate the insertion into the through-hole and the length of the tablet is made greater than that of the through-hole instead.

A carbon jig is used to position and melt the glass tablet in the through-hole so that head 7h of lead 7 protrudes from the inner bottom surface of base body 5 by a predetermined height. Base body 5 is placed on the working surface of the jig with its inner bottom surface facing down, lead 7 to which the glass tablet is fitted is inserted into the through-hole, heated so as to bake and melt the glass. In this case, the outer bottom surface of base body 5 faces up, and melted glass 6 climbs up along the lead, and as a result, glass 6 is formed so as to protrude from the outer bottom surface of base body 5. The amount of climbing glass depends on the amount of glass tablet.

After metal base 2 is formed in this way, the horizontal portion of L-shaped supporter 8 is bonded to head 7h of each lead 7 by spot welding. The reason that head 7h has a greater diameter than those of other parts of lead 7 is to bond supporter 8 thereto. Each supporter 8 has the horizontal portion aligned in the radial direction of metal base 2 and is also arranged so that an end at which the vertical portion is provided is directed the outer perimeter of metal base 2.

Crystal blank 1 is a circular SC-cut crystal blank as shown in FIG. 1C and excitation electrodes 4a are formed on both principal planes thereof. Lead-out electrode 4b extends from excitation electrode 4a on each principal plane of crystal blank 1 toward the perimeter of crystal blank 1. Here, the pair of lead-out electrodes 4b extend from excitation electrodes 4a toward both ends of one diameter of crystal blank 1 and are formed so as to fold back at the position of the perimeter of crystal blank 1 between both principal planes of crystal blank 2.

In such crystal blank 1, a pair of perimeter ends to which lead-out electrodes 4b outwardly extend are bonded to a pair of opposed supporters 8 with eutectic alloy (not shown) such as AuGe. Furthermore, the perimeter ends of crystal blank 1 are also bonded to another pair of opposed supporters 8 with a eutectic alloy likewise. In this case, electrode layers are also locally formed beforehand at perimeter ends of crystal blank 1 for bonding with supporters 8 at positions where no lead-out electrode 4b is formed. Japanese Patent Laid-Open No. 2002-261566 (JP-2002-261566A) discloses a configuration in which perimeter ends of the crystal blank are bonded to the supporters by means of brazing metal at positions where lead-out electrodes are formed, while perimeter ends are bonded to the supporters by means of an adhesive at positions where no lead-out electrode is formed so that the amount of brazing metal used is reduced. U.S. Patent No. 7,061,164 discloses a configuration for avoiding peeling or the like from occurring when the supporters are bonded to the perimeter of the crystal blank using eutectic alloy.

Metal cover 3 is bonded to the perimeter of metal base 2 to hermetically encapsulate crystal blank 1. Here, metal cover 3 is formed into a shape having a recessed part and a ring-shaped flange is formed so as to surround the opening of the recessed part. A ring-shaped flange member whose central portion is dented is also bonded to the perimeter of base body 5. By bonding the flange member of base body 5 and the flange of metal cover 3 together by cold welding, a container made up of metal base 2 and metal cover 3 is formed and crystal blank 1 is hermetically encapsulated within the container. An airtightness of the container of, for example, 10⁻¹¹ is assured and this prevents the vibration frequency of crystal blank 1 from varying due to air leakage in the container.

The SC-cut crystal unit completed in this way is mounted on a wiring board as shown in US 2007/0057742. When the crystal unit is mounted on the wiring board, leads 7 are cut to predetermined lengths according to the thickness of the wiring board, leads 7 are inserted into the through-holes of the wiring board to fix ends of leads 7 to the wiring board by soldering. If the thickness of the wiring board is, for example, 0.6 mm, leads 7 are cut to a length of, for example, 0.7 mm. The wiring board is mounted with an integrated circuit (IC) with a built-in oscillation circuit using the crystal unit and a temperature control element or the like beforehand. It is possible to construct a oven-controlled crystal oscillator (OCXO) by mounting an SC-cut crystal unit on this wiring board. Such a oven-controlled crystal oscillator has a high degree of frequency stability of, for example, 0.03 ppm/year or less and is thereby used as a high stability frequency source at a base station on a wireless communication network.

However, with the crystal unit in the above described configuration, when leads 7 are cut to a predetermined length using, for example, nippers in order to insert leads 7 into the through-holes of the wiring board, a mechanical shock is applied to leads 7, which causes leads 7 to bend. As a result, small crazing may occur in sealing glass 6 in the through-holes at the root of lead 7 as shown with "x" marks in FIG. 2, and cracking as shown with lines in the figure may occur starting from these points. Such cracks are noticeable when the glass climbs up along the surface of the leads.

The occurrence of such cracks produces serious air leakage in the container, resulting in a problem that the airtightness of 10⁻¹¹ in the container is lost. Cracking in glass 6 may easily occur not only at the time of cutting of lead 7 but also during transportation in a manufacturing process or the like due to even small bending of lead 7 in the direction shown by arrows in the figure when lead 7 comes into contact with a jig or tool.

MIL standard MIL-H-10056/22A shows a crystal unit having a base made of glass. In the glass base, a pair of leads penetrate and a flange is formed at the perimeter. Each lead is made up of a supporter, a first lead portion and a second lead portion smaller in diameter than the first lead portion, and the supporter and the lead portions are formed as one piece. Since this glass base is molded and manufactured integral with the leads, the placement of a jig or the like during manufacturing prevents the occurrence of a phenomenon of glass climbing up along the surface of the leads. Therefore, the above described occurrence of cracks in glass due to the occurrence of a phenomenon of glass climbing up is also suppressed when a shock is applied to the leads. However, since this crystal unit uses the glass base, the crystal unit is susceptible to mechanical shock such as a fall and easily damaged, and moreover since the glass base has a small thermal conductivity, the crystal unit involves a major problem that it is not suitable for applications as an oven-controlled crystal oscillator. Furthermore, since the portion where the glass base and metal cover are bonded is long, the crystal unit has another problem that it is difficult to keep the airtightness.

### SUMMARY OF THE INVENTION

It is an object of an embodiment to provide a metal base for a crystal unit capable of preventing cracks in sealing glass and reliably securing the airtightness of a container.

It is another object of an embodiment to provide a crystal unit capable of preventing cracks in sealing glass in a metal base, reliably securing the airtightness of a container and thereby realizing a stable operation.

One embodiment of the present invention provides a metal base for a crystal unit which includes: a base body having first and second principal surfaces in which at least a pair of through-holes are formed; a pair of leads that penetrate the through-holes, extend out of the second principal surface, and have a head protruding from the first principal surface; a supporter connected to each head to support a crystal blank; and glass charged into the respective through-holes to electrically insulate the leads from the base body and hermetically seal the through-holes, wherein a step point is set in a region of the lead corresponding to the second principal surface, the lead comprises a first lead portion on the through-hole side from the step point and a second lead portion in a direction in which the lead extends out from the step point, and a diameter of the lead of the second lead portion is smaller than a diameter of the lead of the first lead portion.

In some embodiments the lead has a first lead portion on the through-hole side and a second lead portion in the direction in which the lead extends out and these portions border on the step point set in a region corresponding to the second principal surface of the base body. The second lead portion has a smaller diameter than that of the first lead portion. According to such a configuration compared to the case where the first and second lead portions have the same diameter, even when a shock is applied to or bending occurs in the second lead portion, for example, at the time of cutting, the first lead portion having a larger diameter than the second lead portion absorbs the shock or bending. The absorption of the shock and bending prevents cracks from occurring in the glass at the root of the lead in the region corresponding to the boundary with the outer bottom surface of the base body, and can thereby reliably keep the airtightness of the container.

In such a metal base, the stepped surface formed in the lead at the step point is preferably exposed without being covered with glass.

In the metal base of one embodiment the second principal surface of the base body and the stepped surface of the lead are located within the same plane, and therefore when the second lead portion is inserted into the through-hole of the wiring board and the crystal unit having this metal base is mounted on the wiring board, the outer bottom surface of the metal base comes into contact with the surface of the wiring board, and it is thereby possible to reduce the mounting height of the crystal unit. Furthermore, this configuration causes the portion of glass climbing up along the lead to become symmetric in shape to the portion climbing up along the inner side surface of the through-hole, uniformly distributes stress applied to the glass and reliably prevents cracks from occurring in the glass.

In the metal base of one embodiment a dent may also be formed, which circulates around the perimeter of the through-hole and is contiguous to the through-hole, in the base body on the second principal surface. The provision of the dent allows, even when the amount of glass is large, the melted glass to flow into the dent, can thereby prevent the glass from climbing over the stepped surface or second lead portion and more reliably prevent cracks from occurring in the glass.

Another embodiment of the present invention provides a crystal unit including a crystal blank having a pair of excitation electrodes on both principal planes, the above described metal base that holds the crystal blank and a metal cover bonded to the metal base, wherein a lead-out electrode extends out from each excitation electrode of the crystal blank toward a perimeter end of the crystal blank, the crystal blank is hermetically housed within a container formed of the metal base and the metal cover and the supporter and excitation electrode are electrically connected.

Using the aforementioned metal base, the crystal unit of the embodiments
can reliably keep the airtightness of the container and keep the
vibration characteristic of the crystal blank satisfactorily.

### BRIEF DESCRIPTION OF THE DRAWINGS

FIG. 1A is a cross-sectional view showing an example of the structure of a conventional crystal unit having an SC-cut crystal blank;
FIG. 1B is a plan view of the crystal unit shown in FIG. 1A with the cover removed;
FIG. 1C is a plan view showing an example of the SC-cut crystal blank;
FIG. 2 is a partially enlarged cross-sectional view of the portion enclosed by a dotted line in FIG. 1A;
FIG. 3 is a partially enlarged cross-sectional view of a metal base in a crystal unit according to a first embodiment of the present invention;
FIG. 4 is a partially enlarged cross-sectional view of the metal base shown in FIG. 3 after the second lead portion is cut to a predetermined length;
FIG. 5 is a partially enlarged cross-sectional view of the portion enclosed by a dotted line in FIG. 3;
FIG. 6 is a partially enlarged cross-sectional view of a metal base in a crystal unit according to a second embodiment of the present invention; and
FIG. 7 is a partially enlarged cross-sectional view of a metal base in a crystal unit according to a third embodiment of the present invention.

### DETAILED DESCRIPTION OF THE PREFERRED EMBODIMENTS

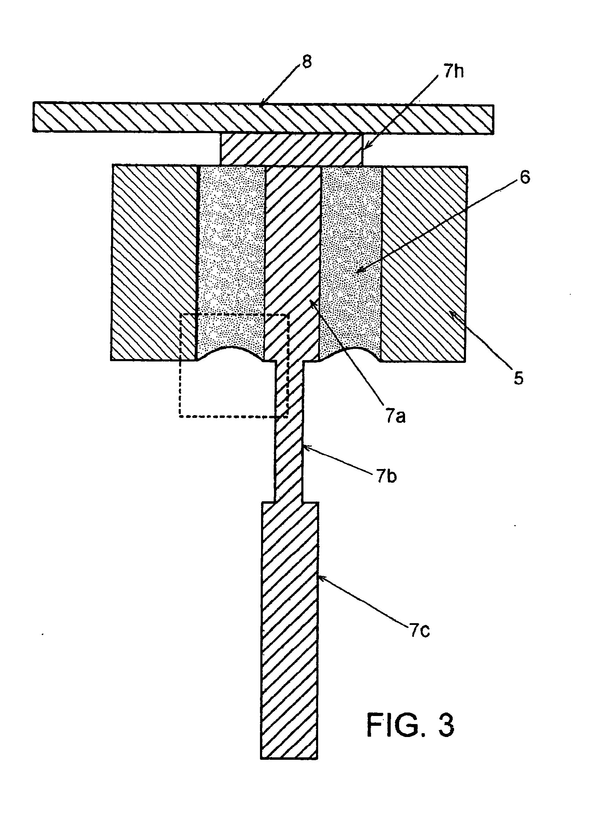

The crystal unit according to a first embodiment of the present invention is similar to the conventional SC-cut crystal unit shown in FIGS. 1A and 1B, but is different from the conventional one in the configuration of the lead. Therefore, FIG. 3 that shows the crystal unit of the first embodiment is described as a partially enlarged cross-sectional view centered on the portion where lead 7 of metal base 2 penetrates base body 5. In the following descriptions, the same components as those shown in FIGS. 1A and 1B will be assigned the same reference numerals and overlapping explanations of these components will be simplified or omitted. The parts not shown in FIG. 3 of the crystal unit of this embodiment are identical to those shown in FIGS. 1A and 1B.

The SC-cut crystal unit is provided with metal base 2, SC-cut crystal blank 1 held on metal base 2, and metal cover 3 bonded to metal base 2. Metal base 2 includes a metallic base body 5 having a plurality of through-holes, leads 7 inserted into these through-holes, support 8 that is provided at head 7h of each lead 7 and supports crystal blank 1, and glass 6 that is charged into the through-holes to electrically insulate leads 7 from base body 5 and hermetically seal the through-holes. Here, head 7h is also formed into a small disk-like shape, protrudes from the inner bottom surface of base body 5 and the bottom surface of head 7h contacts glass 6. Each lead 7 is formed into a T-shape here, too.

In lead 7 of metal base 2, a step having a right-angled L-shaped cross section is formed within a region corresponding to the outer bottom surface. Of the lead, the portion on the through-hole side from the step is first lead portion 7a and the portion extending from the step in a protruding direction from base body 5 is second lead portion 7b. The diameter of second lead portion 7b is smaller than the diameter of first lead portion 7a. In this example, the step is located within the same plane as the outer bottom surface of base body 5.

Of lead 7, the further portion from second lead portion 7b in the extending direction of the lead constitutes third lead portion 7c and third lead portion 7c has the same diameter as that of the first lead portion. Glass 6 in the through-hole climbs up along the inner wall of the through-hole in the direction of the outer bottom surface of base body 5 and also climbs up along first lead portion 7a in the direction of the step. However, glass 6 neither climbs up beyond the position of the edge of the through-hole in the outer bottom surface nor climbs over the surface of the step formed by the first and second lead portions of lead 7. As a result, the surface of glass 6 is formed into a concave surface as a dent having an arc-shaped cross section.

In lead 7, first, second and third lead portions 7a to 7c are arranged in this order. Such lead 7 is manufactured through machining by making a wire rod spin around its longitudinal axis, grinding the wire rod with an end of a grinding tool contacting the surface of this wire rod and thereby forming second lead portion 7b having a small diameter between first lead portion 7a and third lead portion 7c. Alternatively, lead 7 is manufactured by preparing a wire rod whose positions corresponding to first and third lead portions 7a and 7c are masked and applying etching work to this wire rod whereby the wire rod is etched in a liquid.

When metal base 2 is formed using such lead 7, a tablet made of glass powder molded and solidified into a cylindrical shape is prepared and this tablet is fitted to first lead portion 7a of lead 7. Suppose the outer diameter of the tablet is smaller than the diameter of the through-hole of base body 5 and the length thereof is equivalent to or greater than the length of first lead portion 7a. As described above, the glass tablet is melted by heating the tablet while keeping the protruding height of head 7h from the inner bottom surface of base body 5 to a specified value using a carbon jig (not shown).

As a result, the melted glass spreads inside the through-hole and the through-hole is filled with glass, and this glass is bonded to the inner surface of the through-hole and the outer surface of first lead portion 7a. In this case, the melted glass climbs up along lead 7 and the inner surface of the through-hole on the outer bottom surface side of base body 5. The climbing length of glass is equal to or lower than the position of the step by first and second lead portions 7a, 7b on the lead 7 side and equal to or lower than the position of the edge with respect to the outer bottom surface on the inner surface of the through-hole. After cooling, metal base 2 is completed. As for metal base 2, head 7h of lead 7 protrudes by a specified height from the inner bottom surface of base body 5.

Next, as described above, support 8 is bonded to head 7h, crystal blank 1 is held by support 8, metal cover 3 is bonded to metal base 2 and the SC-cut crystal unit is thereby completed.

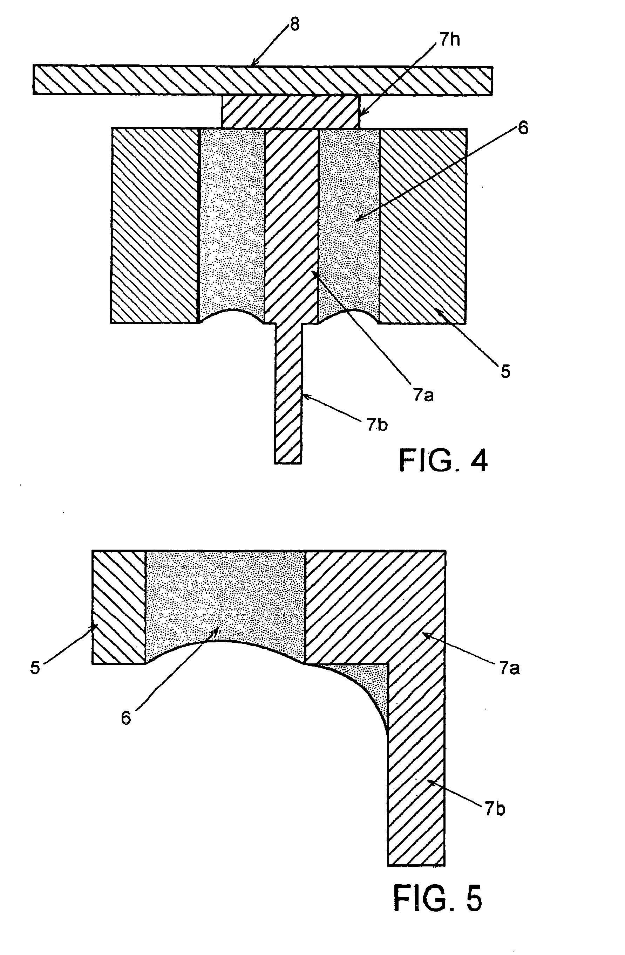

In the completed crystal unit, second lead portion 7b is cut to a predetermined length as shown in FIG. 4 according to the thickness of the wiring board on which the crystal unit is mounted. When, for example, the thickness of the wiring board is 0.6 mm, second lead portion 7b is cut at a position where the distance from the step of first lead portion 7a is 0.7 mm. Second lead portion 7b is then inserted into a through-hole of the wiring board together with other circuit elements making up an oscillation circuit, the protruding end of the lead is soldered and the crystal unit is thereby mounted on this wiring board. Since third lead portion 7c is intended for working on second lead portion 7b, third lead portion 7c may be cut and removed before lead 7 is inserted into the through-hole of base body 5.

In this crystal unit, a stepped surface by first and second lead portions 7a, 7b is formed at the position of lead 7 corresponding to a boundary with the outer bottom surface of base body 5, in other words, in the vicinity of the position of lead 7 corresponding to the outer bottom surface. This stepped surface is exposed. In this example, the stepped surface is located within the same plane as that of the outer bottom surface of base body 5. On the stepped surface 7a, the end face of first lead portion 7a is partially exposed and second lead portion 7b having a smaller diameter than that of first lead portion 7a extends outward. In this configuration, a mechanical shock produced when cutting second lead portion 7b is absorbed by first lead portion 7a and the shock on glass 6 is cushioned. Moreover, since the stepped surface is exposed and no glass 6 climbs up here, second lead portion 7b having the smaller diameter never contacts glass 6. Therefore, bending of second lead portion 7b at the time of cutting or during transportation never causes cracks or the like in glass 6 and it is possible to keep the airtightness of the container made up of metal base 2 and metal cover 3 satisfactorily.

Even when the amount of melted glass is so large that the glass climbs up over the stepped surface, as shown in FIG. 5, the glass floods over the stepped surface first and then climbs up from the stepped surface over second lead portion 7b. As a result, the glass on the through-hole side is substantially separated from the glass on the stepped surface at the position of the perimeter end of the stepped surface. In this case, crazing, cracking or the like may occur in the glass on the stepped surface due to a shock to or bending of second lead portion 7b, but such crazing and cracking do not have any ripple effect on glass 6 in the through-hole. The airtightness of the container is still kept by glass 6 in the through-hole.

In the example shown here, since the stepped surface by first and second lead portions 7a, 7b is located within the same plane as the outer bottom surface of base body 5, when the completed crystal unit is mounted on the wiring board, the outer bottom surface of base body 5 can contact the surface of the wiring board and the mounting height of the crystal unit can be thereby reduced. However, the stepped surface need not be located within the same plane as the outer bottom surface of base body 5, and there can be some positional difference between the two surfaces and even when, for example, there is some positional difference between both surfaces within a range of ±0.2 mm, the effect of suppressing the mounting height is obtained.

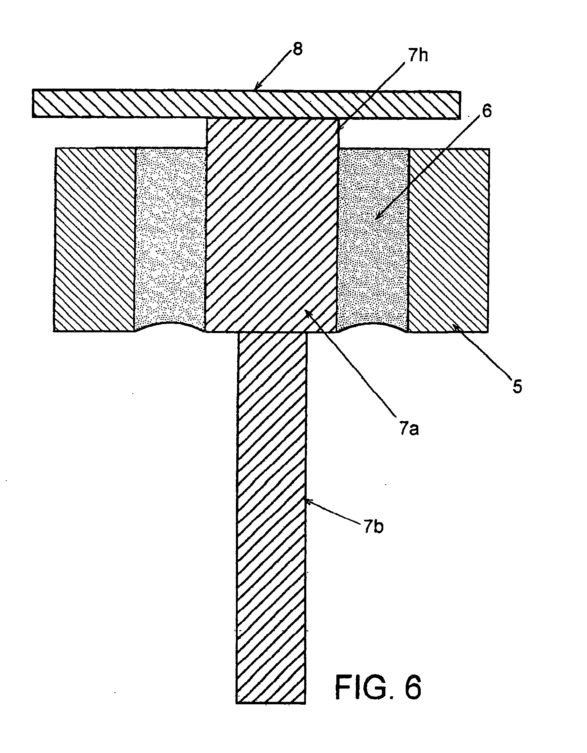

FIG. 6 shows a crystal unit according to a second embodiment of the present invention. Since the crystal unit of the second embodiment is different from the first embodiment only in the shape of the lead, FIG. 6 is described as a partially enlarged cross-sectional view showing only the lead and a portion in the vicinity thereof.

According to the first embodiment, head 7h of lead 7 protruding from the inner bottom surface of base body 5 has a shape like the head of a nail and has a greater diameter than that of first lead portion 7a, but according to the second embodiment, head 7h of lead 7 also has the same diameter as that of first lead portion 7a. Second lead portion 7b having a smaller diameter than that of first lead portion 7a extends out of first lead portion 7a on the outer bottom surface side of base body 5 as in the case of the first embodiment. In this example, the stepped surface by first and second lead portions 7a, 7b is located within the same plane as the outer bottom surface of base body 5 and exposed. Glass 6 climbs up along lead 7 and the inner surface of through-hole in an end region of base body 5 on the outer bottom surface side in the through-hole, and in this way the surface of glass 6 is formed into a concave surface. The climbing length of glass is equal to or lower than the position of the stepped surface on the lead 7 side and is equal to or lower than the position of the outer bottom surface of base body 5 on the inner surface side of the through-hole.

In this embodiment, lead 7 is formed by bonding a wire rod to be second lead portion 7b and having a smaller diameter than that of the wire rod to be first lead portion 7a to the wire rod to be first lead portion 7a through end face welding. The use of end face welding causes the diameter of first lead portion 7a to become greater than that in the first embodiment. Therefore, the diameter of the through-hole provided in base body 5 is also made greater accordingly and the amount of glass 6 used is also increased so as to keep the airtightness of the container made up of metal base 2 and metal cover 3.

When metal base 2 is formed using such lead 7 in this embodiment, a tablet made of glass powder solidified and molded into a cylindrical shape is fitted to first lead portion 7a of lead 7. In that case, the tablet is prevented from fitting to the portion to be head 7h. Lead 7 fitted with the glass tablet is inserted into the through-hole of the base body, heated to melt the glass tablet as described above. As a result, head 7h protrudes from the inner bottom surface of base body 5 and glass climbs up along the lead and the inner surface of the through-hole on the outer bottom surface side of base body 5. The climbing length of glass is controlled so as to be equal to or lower than the position of the stepped surface of lead 7 and equal to or lower than the position of the outer bottom surface of base body 5.

In the second embodiment as in the case of the first embodiment, the stepped surface by first and second lead portions 7a, 7b is exposed and second lead portion 7b extends outward from here, and therefore a shock produced when second lead portion 7b is cut is absorbed by first lead portion 7a having a greater diameter than this. Since there is no climbing glass 6 on the stepped surface, the bending of second lead portion 7b at the time of cutting or during transportation has no influence on glass 6. This prevents cracks from occurring in glass 6 and allows the airtightness of the container to be kept satisfactorily.

In this embodiment as in the case of the first embodiment, second lead portion 7b of lead 7 having a smaller diameter can also be formed through machining or etching.

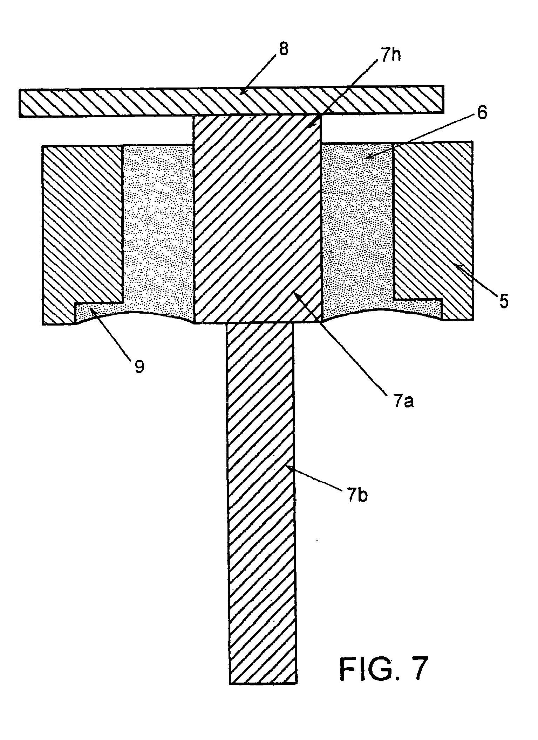

FIG. 7 shows a crystal unit according to a third embodiment of the present invention. Since the crystal unit of the third embodiment is different from that of the second embodiment only in the shape in the vicinity of the through-hole of the base body, FIG. 7 is described as a partially enlarged cross-sectional view showing only the lead, through-hole and a portion in the vicinity thereof.

In the third embodiment, annular groove 9 is formed along the circumference of the through-hole on the outer bottom face of base body 5. There is no wall at the boundary between annular groove 9 and the through-hole and annular groove 9 is united with the through-hole. In other words, a dent contiguous to the through-hole is formed along the circumference of the through-hole on the outer bottom surface of base body 5. In this embodiment, when a glass tablet fitted to lead 7 is melted to seal the through-hole, if the amount of glass is large, the melted glass flows into groove 9 and this prevents the glass from climbing up over the stepped surface of lead 7 or prevents the glass from contacting second lead portion 7b. The provision of such groove 9 allows the climbing length of glass fi after solidification to be equal to or lower than the position of the stepped surface or equal to or lower than the position of the outer bottom surface of base body 5, and can thereby prevent cracks from occurring in glass 6 due to a shock applied to or bending of second lead portion 7b. According to this embodiment, it is possible to reliably keep the airtightness of the container.

The provision of groove 9 is applicable to any case where the second lead portion is formed through machining, etching or end face welding. It goes without saying that the diameter of head 7h of lead 7 may be greater than the diameter of first lead portion 7a.

The preferred embodiments of the present invention have been explained so far in the case where crystal blank 1 is an SC-cut quartz crystal blank, but the crystal blank to which the present invention is applicable is not limited to this. For example, the present invention is also applicable to an AT-cut or BT-cut quartz crystal blank. Furthermore, the case where four through-holes are provided in base body 5, leads 7 are inserted into the respective through-holes and the respective through-holes are sealed with glass 6 to make up a hermetic terminal has been explained, but the number of through-holes provided in base body 5 is not limited to four. For example, only two through-holes may be provided in the base body and leads 7 may be inserted into the respective through-holes to make up a hermetic terminal.

## Claims

1. A metal base for a crystal unit, comprising:
a base body having first and second principal surfaces in which at least a pair of through-holes are formed;
a pair of leads that penetrate the through-holes, extend out of the second principal surface, and have a head protruding from the first principal surface;
a supporter connected to each head to support a crystal blank; and
glass charged into the respective through-holes to electrically insulate the leads from the base body and hermetically seal the through-holes,
wherein a step point is set in a region of the lead corresponding to the second principal surface, the lead comprises a first lead portion on the through-hole side from the step point and a second lead portion in a direction in which the lead extends out from the step point, and
a diameter of the lead of the second lead portion is smaller than a diameter of the lead of the first lead portion.

2. The metal base according to claim 1, wherein a surface of the glass is formed into a concave surface shape at an end of the through-hole on the second principal surface side so as to climb up toward the step point and toward position of a perimeter of the through-hole on the second principal surface.

3. The metal base according to claim 1 or 2, wherein in the step point, the stepped surface formed in the lead is exposed.

4. The metal base according to claim 3, wherein the second principal plane and the stepped surface are located within a same plane.

5. The metal base according to claim 2, wherein on the second principal surface, a dent circulating along the perimeter of the through-hole and contiguous to the through-hole is formed in the base body and the glass enters the dent.

6. The metal base according to claim 3, wherein on the second principal surface, a dent circulating along the perimeter of the through-hole and contiguous to the through-hole is formed in the base body and the glass enters the dent.

7. The metal base according to any preceding claim, wherein the head is formed into a disk-like shape having a greater diameter than that of the first lead portion.

8. The metal base according to claim 7, wherein the first lead portion and the second lead portion are made to have different diameters by carrying out machining or etching.

9. The metal base according to any preceding claim, wherein the lead is formed by carrying out end face welding between the first lead portion and the second lead portion and the head has the same diameter as that of the first lead portion.

10. A crystal unit comprising:
a crystal blank having a pair of excitation electrodes on both principal planes;
a metal base that holds the crystal blank; and
a metal cover bonded to the metal base,
wherein a lead-out electrode extends out from each excitation electrode of the crystal blank toward a perimeter end of the crystal blank,
wherein the crystal blank is hermetically encapsulated within a container formed of the metal base and the metal cover,
wherein the metal base comprises:
a base body having first and second principal surfaces in which at least a pair of through-holes are formed;
a pair of leads that penetrate the through-holes, extend out of the second principal surface and have a head protruding from the first principal surface;
a supporter connected to each head to support the crystal blank; and
glass charged into the respective through-holes to electrically insulate the leads from the base body and hermetically seal the through-holes,
wherein the supporter is electrically connected to the excitation electrode,
wherein a step point is set in a region corresponding to the second principal surface of the lead, the lead comprises a first lead portion on the through-hole side from the step point and a second lead portion in a direction in which the lead extends out from the step point, and
wherein a diameter of the lead of the second lead portion is smaller than a diameter of the lead of the first lead portion.

11. The crystal unit according to claim 10, wherein at an end of the through-hole on the second principal surface side, a surface of the glass is formed into a concaved surface shape so as to climb up toward the step point and toward position of a perimeter of the through-hole on the second principal surface.

12. The crystal unit according to claim 10, wherein the crystal blank is an SC-cut crystal blank.
